# EUROPÄISCHE PATENTSCHRIFT

(11) **EP 3 379 716 B1**
(45) Veröffentlichungstag und Bekanntmachung des Hinweises auf die Patenterteilung: **06.04.2022**
(21) Anmeldenummer: 18159067.0
(22) Anmeldetag: 28.02.2018
(51) Int. Cl.: H02M 7/5395, H02M 1/00, H02P 27/08, G01R 19/165, G01R 19/25, B62D 5/04

(54) **STROMMESSVERFAHREN IN EINEM MITTELS PWM ANGESTEUERTEN LENKHILFSANTRIEB**
CURRENT MEASUREMENT METHOD IN A PWM CONTROLLED DRIVE OF A STEERING AID
PROCÉDÉ DE MESURE DE COURANT DANS UN ACTUATEUR ÉLECTRIQUE PILOTÉ PAR M.L.I. POUR UNE DIRECTION ASSISTÉE

(30) Priorität: 02.03.2017 DE 102017203457
(43) Veröffentlichungstag der Anmeldung: 26.09.2018
(73) Patentinhaber: VOLKSWAGEN AKTIENGESELLSCHAFT, 38440 Wolfsburg (DE)
(72) Erfinder: Gohlke, Daniel, 38553 Wasbüttel (DE); Gohlke, Julia, 38553 Wasbüttel (DE); Wartmann, Nadine, 38179 Schwülper (DE)

(56) Entgegenhaltungen:
- EP-A2- 1 526 060
- EP-A2- 1 737 117
- EP-A2- 2 273 668
- US-A1- 2013 026 960

## Beschreibung

Die vorliegende Erfindung betrifft ein Strommessverfahren, ein Betriebsverfahren, eine Lenkhilfe, ein Computerprogrammerzeugnis und eine Arbeitsvorrichtung. Die vorliegende Erfindung betrifft insbesondere ein Strommessverfahren bei einem Betriebsverfahren für einen mittels eines Modulationsmusters in Pulsweitenmodulation betriebenen dreiphasigen elektromechanischen Antrieb einer Lenkhilfe, ein Betriebsverfahren für einen derartigen elektromechanischen Antrieb einer Lenkhilfe, eine Lenkhilfe als solche, ein Computerprogrammerzeugnis zur Realisierung des Stromessverfahrens und/oder des Betriebsverfahrens sowie ein Fahrzeug.

Arbeitsvorrichtungen und insbesondere Fahrzeuge werden aktuell häufig mit Lenkhilfen ausgestattet. Derartige Lenkhilfen sollen den Bediener der Arbeitsvorrichtung, insbesondere eines Fahrzeugs, bei der Lenkung im Sinne einer Servolenkung unterstützen oder bei so genannten Fahrassistenzverfahren das Lenken oder Teile davon selbst übernehmen. Derartige Lenkhilfen sind mit einem Antrieb für entsprechende Lenkmittel ausgebildet. Ein derartiger Antrieb wird als elektromechanischer Antrieb häufig auf der Grundlage von Modulationsmustern in Pulsweitenmodulation betrieben, bei welchen der Ansteuergrad des Antriebs als Pulsweite oder Pulsbreite eines auf einer Trägerfrequenz modulierten Pulses kodiert wird.

Zur Regelung und/oder Plausibilisierung des Betriebs und insbesondere der Stellung des Antriebs und insbesondere des Lenkmittels werden während des Betriebs üblicherweise Strommessungen durchgeführt. Eine Strommessung kann zeitlich nur außerhalb der Modulationsmuster der Ansteuerung durch die Pulsweitenmodulation erfolgen.

Sicherheitsbedingungen, die an eine Lenkhilfe gestellt werden, erfordern eine häufig wiederkehrende Strommessung, die oft zyklisch durchgeführt wird. Es können daher Situationen entstehen, in denen zyklisch wiederkehrend auf Grund der Musterlage bei der Pulsweitenmodulation kein ausreichend breites zeitliches Auswerteintervall für eine Strommessung vorliegt.

Die Druckschrift US 2013/0264974 A1 beschreibt eine Mehrphasenrotationseinrichtung, bei welcher über eine Mehrzahl von Schalteinrichtungen ein Pulsweitenmodulationsverfahren zur Versorgung der Rotationseinrichtung mit elektrischer Energie ausgeführt wird.

Die Druckschrift US 2012/0118662 A1 offenbart eine Motorsteuereinrichtung und ein elektrisches Steuersystem, bei welchen im Zusammenhang mit einer Strommessung eine Blindkorrektur ausgeführt wird.

US 2013/026960 A1 offenbart eine Antriebsvorrichtung mit einem bürstenlosen Motor, die mit einer Stromerfassungseinrichtung zum Erfassen von Strömen versehen ist, die durch Ankerwicklungen während Perioden fließen, in denen Schaltelemente einer Antriebsschaltung eingeschaltet sind; eine Berechnungsverarbeitungseinrichtung zum Vergleichen eines Zielstromwerts und des erfassten Stromwerts und Berechnen von Spannungsbefehlswerten, die an die Ankerwicklungen angelegt werden sollen, und eine PWM-Ansteuereinrichtung zum Steuern des EIN / AUS der Schaltelemente auf der Basis des Spannungsbefehls Werte. Die Berechnungsverarbeitungseinrichtung ist ferner mit einer Stromerfassungsmöglichkeit versehen, mit der bewertet werden kann, ob die durch die Ankerwicklungen fließenden Ströme erfasst werden können oder nicht, mit den Betriebszuständen der Schaltelemente jeder der Phasen und wann der Strom Auswertungsmittel zur Erfassung der Erfassungsmöglichkeit bewertet, dass die Ströme nicht erfasst werden können, das Berechnungsverarbeitungsmittel erhält die Spannungsbefehlswerte unter Verwendung der Stromwerte, die erfasst werden, wenn die Ströme erfasst werden können, und setzt den Motorantrieb fort.

EP 2 273 668 A2 zeigt eine Motorsteuerung mit einem Mikrocomputer. Wenn die Einschaltzeit eines der niederpotentialseitigen FETs, die den jeweiligen Phasen in einer Ansteuerschaltung entsprechen, kürzer wird als die Erfassungszeit zum Erfassen des Phasenstromwerts, schätzt der Mikrocomputer den Phasenstromwert der nicht nachweisbaren elektrischen Stromphase basierend auf Phasenstromwerten der beiden Phasen außer derjenigen nicht nachweisbaren elektrischen Stromphase, die dem relevanten FET entspricht (Blindschätzung), ab. Wenn bei der Blindschätzung eine elektrische Stromerfassung durchgeführt wird, werden Motorsteuersignale ausgegeben, durch die der Schaltzustand des Schaltarms der nicht nachweisbaren elektrischen Stromphase aufrechterhalten und der durch den Schaltvorgang der FETs in den beiden Phasen verursachte Leistungsverlust kompensiert wird.

EP 1 526 060 A2 betrifft ein Servolenksystem, das einen Stromdetektor zum Erfassen eines sequentiellen Stroms umfasst, der zu einem erdseitigen Schaltelement in einem Unterarm durch einen Erfassungswiderstand fließt, der nicht nur in einem Zeitraum, in dem das Schaltelement eingeschaltet ist, in den Unterarm eingeführt wird, aber auch in einem Zeitraum, in dem das Schaltelement ausgeschaltet ist, eine Versatzaktualisierungseinheit zum sequentiellen Aktualisieren eines Versatzkorrekturwerts mit erfassten Werten in dem Zeitraum, in dem das Schaltelement ausgeschaltet ist, und eine erfasste Stromkorrektureinheit zum Berechnen eines Motorstromwerts durch Korrigieren der erkannten Werte in dem Zeitraum, in dem das Schaltelement eingeschaltet ist, mit dem Versatzkorrekturwert, wodurch eine Aktualisierung erreicht wird.

EP 1 737 117 A2 offenbart ein Motorsteuersystem, das eine Stromerfassung mit hoher Genauigkeit unter Verwendung eines Verstärkers mit einem gewöhnlichen Genauigkeitsniveau realisieren und eine Verschlechterung der Stromerfassungsgenauigkeit selbst bei Änderung der Temperatur vermeiden kann. Das Motorsteuersystem umfasst eine Schaltschaltung zum Zuführen eines Ansteuerstroms zu einem Motor, einen Widerstand zum Erfassen des Ansteuerstroms, eine Verstärkungsschaltung zum Verstärken einer Potentialdifferenz über dem Widerstand, eine Eingangsabschnitt-Schalteinheit, die in einem Eingangsabschnitt der Verstärkung angeordnet ist und dem Umschalten der Potentialdifferenz dient, um vorwärts oder rückwärts vorgespannt zu sein, eine Ausgangsabschnitt-Schalteinheit, die in einem Ausgangsabschnitt der Verstärkungsschaltung angeordnet ist und eine Ausgangsspannung der Verstärkungsschaltung umschaltet, um vorwärts vorgespannt oder rückwärts vorgespannt zu sein, und eine CPU zum Mitteln einer Spannung, die erzeugt wird, wenn die Ausgangsspannung der Verstärkungsschaltung in Vorwärtsrichtung vorgespannt ist, und einer Spannung, die erzeugt wird, wenn die Ausgangsspannung der Verstärkungsschaltung in Sperrrichtung vorgespannt ist.

Der Erfindung liegt die Aufgabe zu Grunde, ein Strommessverfahren beim Betrieb eines mittels Pulsweitenmodulation betriebenen dreiphasigen elektromechanischen Antriebs einer Lenkhilfe anzugeben, bei welchem mit einfachen Mitteln gültige Strommessungen zu beliebigen Zeitpunkten gewährleistet werden können. Ferner liegt der Erfindung die Aufgabe zu Grunde ein entsprechendes Betriebsverfahren für den Antrieb einer Lenkhilfe, eine Lenkhilfe als solche, ein entsprechendes Computerprogrammerzeugnis und eine entsprechende Arbeitsvorrichtung, insbesondere ein Fahrzeug, anzugeben.

Die der Erfindung zu Grunde liegende Aufgabe wird bei einem Strommessverfahren erfindungsgemäß mit den Merkmalen des unabhängigen Patentanspruchs 1, bei einem Betriebsverfahren erfindungsgemäß mit den Merkmalen des unabhängigen Patentanspruchs 8, bei einer Lenkhilfe erfindungsgemäß mit den Merkmalen des Patentanspruchs 9, bei einem Computerprogrammerzeugnis erfindungsgemäß mit den Merkmalen des unabhängigen Patentanspruchs 10 sowie bei einer Arbeitsvorrichtung und insbesondere bei einem Fahrzeug erfindungsgemäß mit den Merkmalen des Patentanspruchs 11 gelöst. Vorteilhafte Weiterbildungen sind Gegenstand der jeweiligen abhängigen Ansprüche.

Gemäß einem ersten Aspekt der vorliegenden Erfindung wird ein Strommessverfahren bei einem Betriebsverfahren für einen mittels eines Modulationsmusters in Pulsweitenmodulation betriebenen dreiphasigen elektromechanischen Antriebs einer Lenkhilfe geschaffen, bei welchem zu bestimmten Auswertezeiten Ströme zu den drei Phasen erfasst werden, wobei beim Vorliegen einer vordefinierten Bedingung für eine aktive Strommessung zu einer Auswertezeit das Modulationsmuster mindestens einer der Phasen durch Stauchung derart modifiziert wird, dass zu der Auswertezeit zwischen einer Ausschaltflanke der Phase mit dem längsten Modulationsmuster unter den Phasen im aktuellen Takt und einer Einschaltflanke der Phase mit dem längsten Modulationsmuster unter den Phasen im nachfolgenden Takt eine für eine mehrfache Strommessung ausreichende Messzeitspanne geschaffen wird und zu der Auswertezeit in der Messzeitspanne eine Strommessung zu den drei Phasen durchgeführt wird.

Ein Kernaspekt der vorliegenden Erfindung besteht mithin darin, beim Vorliegen von Bedingungen, die eine aktive Strommessung erfordern, also zum Beispiel dann, wenn eine zyklisch angeforderte Strommessung auf Grund eines zu kleinen zeitlichen Auswerteintervalls nicht erfolgen kann, das Modulationsmuster und insbesondere die Pulsbreite oder Pulsweite mindestens einer der Phasen durch Stauchung temporär derart zu modifizieren, dass ein zeitlich ausreichend breites Auswerteintervall entsteht, in welchem die Strommessung ohne Störung durchgeführt werden kann.

Um eine zuverlässige Strommessung, die für den Betrieb des Antriebs einer Lenkhilfe erforderlich ist, gewährleisten zu können, bieten sich unterschiedliche Möglichkeiten an.

Ein besonders hohes Maß an Zuverlässigkeit stellt sich ein, wenn erfindungsgemäß auf das Vorliegen einer vordefinierten Bedingung für eine aktive Strommessung erkannt wird, wenn innerhalb einer ersten und längeren bestimmten Zeitspanne seit einer letzten Strommessung keine Messung der Ströme I_{U}, I_{V}, I_{W} zu allen drei Phasen U, V, W durchgeführt wurde oder werden konnte und/oder wenn innerhalb einer zweiten und kürzeren bestimmten Zeitspanne seit einer letzten Strommessung keine Messung der Ströme I_{U}, I_{V}, I_{W} zu zwei der drei Phasen U, V, W durchgeführt wurde oder werden konnte.

Das erfindungsgemäße Konzept ist insbesondere in Situationen vorteilhaft, in welchen über einen bestimmten Zeitraum hinweg keine Strommessung durchgeführt wurde oder durchgeführt werden konnte. In diesen Fällen wird daher eine aktive Maßnahme, d.h. eine aktive Strommessung gewählt. Im Gegensatz zu den Maßnahmen im Stand der Technik handelt es sich erfindungsgemäß nicht um eine symmetrische Verschiebung des Tastverhältnisses oder des Duty Cycles auf allen Phasen. Vielmehr geht es erfindungsgemäß um eine gezielte oder bewusste Veränderung des Tastverhältnisses oder Duty Cycles mit Stauchung des Pulsmusters zur Ermöglichung einer Strommessung, insbesondere dahingehend, dass durch die Stauchung des Pulsmusters zur Ermöglichung einer Strommessung auch Abweichungen zwischen einem gewünschten Sollmoment und einem erzielten Istmoment des Motors als Fehlmomente in Kauf genommen werden. Erfindungsgemäß werden dabei insbesondere Aussteuergrade angesprochen, bei denen die Anpassungen aus dem Stand der Technik höchstens nachteilig wären. Mit auftretenden Fehlmomenten in Verbindung stehende leichte haptische und/oder akustische Phänomene werden erfindungsgemäß insbesondere reduziert oder verhindert. Dabei ist es zur Unterdrückung akustischer Erscheinungen, zum Beispiel von Resonanzen oder dergleichen, besonders vorteilhaft, wenn die erste Zeitspanne und/oder die zweite Zeitspanne für jeden Takt oder Messdurchgang zufällig bestimmt werden, insbesondere gemäß vorgegebener Wahrscheinlichkeitsverteilungen und/oder innerhalb vorgegebener maximaler Zeitspannen.

Bei der Bewertung der Situation zum Zeitpunkt einer angeforderten aktiven Strommessung können verschiedene Konstellationen der Anregungs- und Pulsmuster der verschiedenen Phasen vorliegen, auf welche unterschiedlich reagiert werden kann, um dadurch ein möglichst geringes Maß an Fehlmoment einer Lenkunterstützung zu erreichen.

Dementsprechend ist es gemäß einer bevorzugten Ausgestaltungsform des erfindungsgemäßen Strommessverfahrens vorgesehen, dass beim Vorliegen einer Bedingung für eine aktive Strommessung eine Strommessung der Ströme I_{U}, I_{V}, I_{W} zu allen drei Phasen U, V, W ohne Änderung der Modulationsmuster durchgeführt wird, wenn die Steuerspannungen zu den Modulationsmustern und die Pulsbreiten der Modulationsmuster zu den drei Phasen U, V, W eine minimale Grenze eines Anteils eines maximalen Ansteuergrads bzw. einer maximalen Pulsbreite nicht überschreiten. In diesem Fall kann ohne Veränderung des Modulationsmusters der drei Phasen U, V, W eine Strommessung in der üblichen Form erfolgen.

Zusätzlich kann beim Vorliegen einer Bedingung für eine aktive Strommessung auf eine Flattopmodulation umgeschaltet und eine Strommessung der Ströme I_{U}, I_{V}, I_{W} zu allen drei Phasen U, V, W durchgeführt werden, wenn die Steuerspannungen zu den Modulationsmustern und die Pulsbreiten der Modulationsmuster zu den drei Phasen U, V, W zwischen einer minimalen Grenze eines Anteils und einer maximalen oberen Grenze eines Anteils eines maximalen Ansteuergrads bzw. einer maximalen Pulsbreite liegen.

Bei der Flattopmodulation wird die Ansteuerung im Gegensatz zur Raumzeigermodulation so durchgeführt, dass die Schalter einer Phase innerhalb einer Schaltperiode nicht geschaltet werden müssen, sondern für die gesamte Periode konstant ein bzw. ausgeschaltet bleiben. Dadurch lassen sich höhere Aussteuergrade erzielen, da weniger HW-Einschränkungen gelten.

Des Weiteren kann bei einer anderen vorteilhaften Ausgestaltung des erfindungsgemäßen Strommessverfahrens beim Vorliegen einer Bedingung für eine aktive Strommessung (i) auf eine Flattopmodulation umgeschaltet werden, (ii) die Steuerspannungen zu den Modulationsmustern und die Pulsbreiten der Modulationsmuster zu den drei Phasen U, V, W auf eine maximale obere Grenze eines Anteils eines maximalen Ansteuergrads bzw. einer maximalen Pulsbreite eingestellt werden und eine Strommessung der Ströme I_{U}, I_{V}, I_{W} zu allen drei Phasen U, V, W durchgeführt werden, wenn die Steuerspannungen zu den Modulationsmustern und die Pulsbreiten der Modulationsmuster zu den drei Phasen U, V, W oberhalb der maximalen oberen Grenze eines Anteils des maximalen Ansteuergrads bzw. der maximalen Pulsbreite liegen.

Um akustische Effekte, die im Zusammenhang mit der zyklischen Strommessung auch bei Verwendung der aktiven Strommessung auftreten können, zu reduzieren oder zu vermeiden, ist es von besonderem Vorteil, wenn die Stauchung des Modulationsmusters oder der Modulationsmuster für eine Zeitspanne erfolgt, welche höchstens in etwa dem Vierfachen einer zu Grunde liegenden Zykluszeit der Pulsweitenmodulation entspricht, insbesondere höchstens in etwa dem Dreifachen der zu Grunde liegenden Zykluszeit, vorzugsweise dem Zweifachen und weiter bevorzugt der zu Grunde liegenden Zykluszeit selbst.

Dabei kann die der Pulsweitenmodulation zu Grunde liegende Zykluszeit 50 µs betragen.

Gemäß einem weiteren Aspekt der vorliegenden Erfindung wird auch ein Betriebsverfahren für einen mittels eines Modulationsmusters in Pulsweitenmodulation betriebenen dreiphasigen elektromechanischen Antriebs einer Lenkhilfe geschaffen, bei welchem zur Regelung und/oder zur Plausibilisierung des Betriebs und/oder der Stellung eines Lenkmittels und insbesondere des Antriebs der Lenkhilfe ein Strommessverfahren gemäß der vorliegenden Erfindung durchgeführt wird.

Des Weiteren schlägt die vorliegende Erfindung auch eine Lenkhilfe zur Unterstützung beim Lenken eines Fahrzeugs mittels eines Lenkmittels einer Lenkeinrichtung vor. Die Lenkhilfe ist mit einer Steuereinheit ausgebildet, welche eingerichtet ist, ein Betriebsverfahren und/oder ein Strommessverfahren gemäß der vorliegenden Erfindung auszuführen.

Gemäß einem weiteren Aspekt der vorliegenden Erfindung wird auch ein Computerprogrammerzeugnis mit einem Computerprogrammcode vorgeschlagen, wobei letzterer eingerichtet ist zu bewirken, dass auf einem Computer oder einem digitalen Signalverarbeitungsprozessor ein erfindungsgemäßes Betriebsverfahren und/oder ein Strommessverfahren gemäß der vorliegenden Erfindung ausgeführt wird, wenn auf dem Computer bzw. dem digitalen Signalverarbeitungsprozessor der Computerprogrammcode abläuft.

Schließlich schlägt die vorliegende Erfindung eine Arbeitsvorrichtung und insbesondere ein Fahrzeug, mit einer Lenkeinrichtung vor, welche ein Lenkmittel und eine erfindungsgemäße Lenkhilfe aufweist.

Kurzbeschreibung der Figuren

Weitere Einzelheiten, Merkmale und Vorteile der Erfindung ergeben sich aus der nachfolgenden Beschreibung und den Figuren.
- Figur 1: ist eine schematische Ansicht einer Ausführungsform des erfindungsgemäßen Fahrzeugs, bei welchem im Zusammenhang mit einer Lenkhilfe das erfindungsgemäße Strommessverfahren zum Einsatz kommen kann.
- Figur 2: zeigt schematisch eine Ausführungsform der erfindungsgemäßen Lenkhilfe mit Fokus auf die Steuerung des Antriebs.
- Figuren 3 bis 5: zeigen in Form von Graphen verschiedene Situationen, die beim erfindungsgemäßen Strommessverfahren gehandhabt werden.
- Figuren 6A bis 7C: illustrieren das Vorgehen beim Übergang zur Flattopmodulation ohne und mit Stauchung.

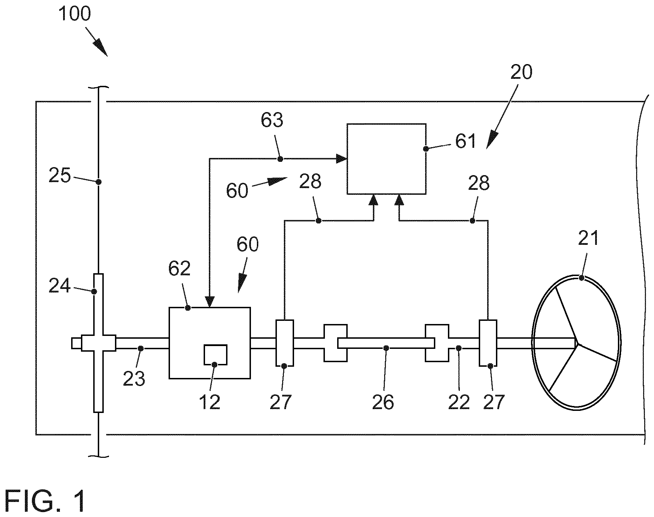

Nachfolgend werden unter Bezugnahme auf die Figuren 1 bis 5 Ausführungsbeispiele und der technische Hintergrund der Erfindung im Detail beschrieben. Gleiche und äquivalente sowie gleich oder äquivalent wirkende Elemente und Komponenten werden mit denselben Bezugszeichen bezeichnet. Nicht in jedem Fall ihres Auftretens wird die Detailbeschreibung der bezeichneten Elemente und Komponenten wiedergegeben.

Figur 1 ist eine schematische Ansicht einer Ausführungsform des erfindungsgemäßen Fahrzeugs 100 oder der Arbeitsvorrichtung im Allgemeinen, bei welchem im Zusammenhang mit einer Lenkhilfe 60 das erfindungsgemäße Strommessverfahren zum Einsatz kommen kann.

Bei der Ausführungsform des erfindungsgemäßen Fahrzeugs 100 gemäß Figur 1 wird auf die Lenkeinrichtung 20 mit Lenkrad 21, primärer Lenkwelle 22, sekundärer Lenkwelle 23, vermittelndem Torsionsstab 26, Lenkgetriebe 24 und Querlenker bzw. Aufhängung als Lenkmittel 25 fokussiert.

Zur Unterstützung einer Lenkbewegung eines Fahrers oder Benutzers bei Betätigung des Lenkrads 21 kann zum Beispiel über die Winkellagesensoren 27, welche über Erfassungsleitungen 28 mit einer Steuereinheit 61 der Lenkhilfe 60 verbunden sind und über diese ausgelesen werden, ein Fahrerwunsch hinsichtlich einer Lenkaktion ermittelt werden. Über die Lenkhilfe 60 mit Steuereinheit 61 und damit verbundenem Antrieb 62 wird dann die Stellung des Lenkgetriebes 24 und folglich des Querlenkers und/oder der Aufhängung als Lenkmittel 25 entsprechend unterstützend eingestellt.

Zur Steuerung oder Regelung des Betriebs des Antriebs 62 und zur Erfassung und Plausibilisierung der Stellung des Lenkgetriebes 24 und des Querlenkers und/oder der Aufhängung als Lenkmittel 25 und/oder des Antriebs 62 als solchem wird mittels einer Messeinrichtung 12 eine Strommessung des den Antrieb 62 antreibenden mehrphasigen Stroms I_{U}, I_{V}, I_{W} durchgeführt.

Eine derartige Strommessung erfolgt üblicherweise zyklisch. Es können jedoch Situationen auftreten, bei welchen eine Strommessung, die eine gewisse Auswertezeitspanne erfordert, über einen bestimmten Zeitraum hinweg nicht durchgeführt werden kann, so dass mehrere geplante Messzyklen ausfallen. In diesem Zusammenhang wird durch die vorliegende Erfindung die Möglichkeit einer aktiven Strommessung geschaffen, indem nämlich beim Vorliegen bestimmter Bedingungen in die Pulsweitenmodulation zur Ansteuerung des Antriebs 62 eingegriffen wird, indem durch Stauchung der jeweiligen Pulsbreiten oder Pulsweiten eine ausreichende Zeitspanne geschaffen wird, welche der Auswertezeitspanne, die für eine Strommessung des mehrphasigen Stroms I_{U}, I_{V}, I_{W} erforderlich ist, entspricht.

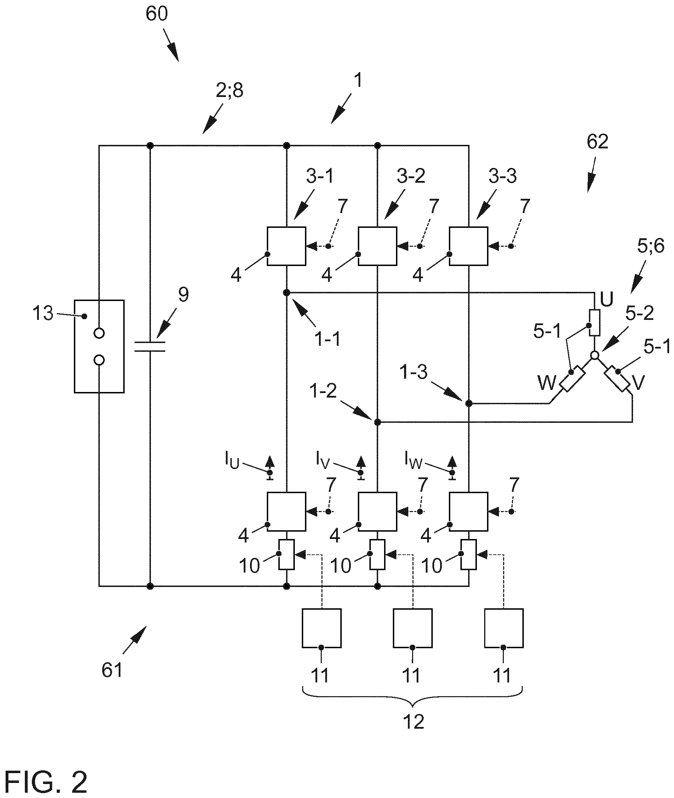

Figur 2 zeigt schematisch eine Ausführungsform der erfindungsgemäßen Lenkhilfe 60 mit Fokus auf die Steuerung 61 des Antriebs 62, die in der Anordnung gemäß Figur 1 über eine gemeinsame Erfassungs- und Steuerleitung 63 miteinander verbunden sind.

Kernelement bei der Anordnung der erfindungsgemäßen Lenkhilfe 60 gemäß Figur 2 ist der Antrieb 62, welcher über die Steuereinheit 61 gesteuert wird. Dazu wird aus einem Gleichstromkreis 2 mit einer Gleichspannungsquelle 13, zum Beispiel einer Batterie, einem parallel geschalteten Zwischenkreiskondensator 9 und einem Wechselrichter 1 als Brückenschaltung mit einem ersten, zweiten und dritten Brückenzweig 3-1, 3-2, 3-3 eine versorgende Gleichspannung zugeführt.

Über mittels Steuereingänge 7 steuerbare Schaltelemente 4, zum Beispiel Halbleiterschaltelemente, welche in Inverterkonfiguration mit entsprechenden Knoten 1-1, 1-2, 1-3 verbunden sind, werden entsprechende Ströme I_{U}, I_{V}, I_{W} zu den Phasen U, V, W erzeugt und einem Drehstrommotor als Verbraucher 5 und als elektrische Maschine 6 mit Induktivitäten 5-1, die über einen Knoten 5-2 als Sternknoten verbunden sind, zum Betrieb zugeführt.

Anstelle einer Sternkonfiguration sind auch im Dreieck verschaltete Antriebe mit dem erfindungsgemäßen Vorgehen steuerbar.

Über Shuntwiderstände 10 können mittels der Messwertwandler 11 der Messeinrichtung 12 und zur Steuerung des Betriebs des Antriebs 62 in gesteuerter Weise die Ströme I_{U}, I_{V}, I_{W} zu den Phasen U, V, W erfasst werden.

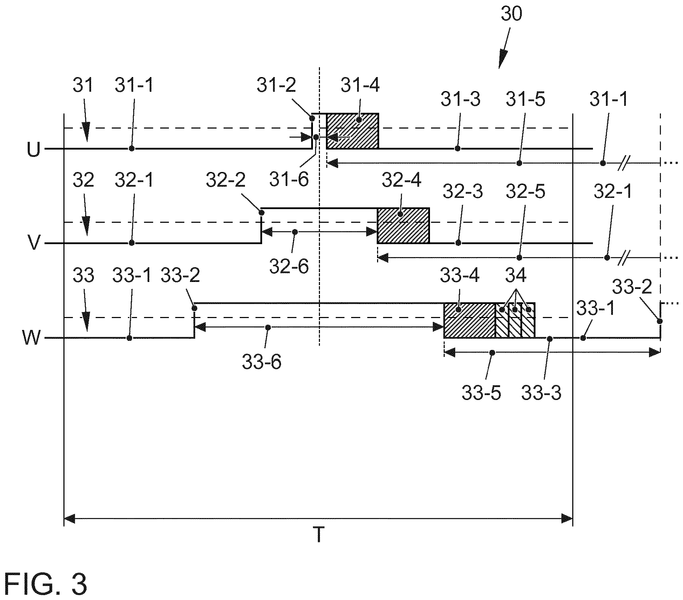

Die Figuren 3 bis 5 zeigen in Form von Graphen 30 verschiedene Situationen, die beim erfindungsgemäßen Strommessverfahren gehandhabt werden können.

In den Figuren 3 bis 5 ist in jedem der Graphen 30 für jede der Phasen U, V, W eine Spur 31, 32, 33 für ein entsprechendes Pulsweitenmodulationssignal mit einem vorangehenden Abschnitt 31-1, 32-1, 33-1 mit einem jeweiligen niedrigen Pegel, einem nachfolgenden Abschnitt 31-3, 32-3, 33-3 mit einem jeweiligen niedrigen Pegel und einem jeweils dazwischen vorgesehenen Abschnitt 31-2, 32-2, 33-2 mit einem hohen Pegel, der auch als eigentlicher Puls bezeichnet wird, ausgebildet.

Der gesamte Verlauf der Steuerung des Antriebs 62 ist in Zyklen der Länge T untergliedert, wobei T einen Wert zum Beispiel von 50 µs, entsprechend einer Abtastfrequenz von 20 kHz aufweist. Andere Werte für die Zykluszeit T oder die Abtastfrequenz sind denkbar und werden dem jeweiligen Anwendungsfall entsprechend angepasst.

Die Zeitspannen 31-6, 32-6, 33-6 der Pulse 31-2, 32-2, 33-2, also die Pulsweiten, definieren einen zur Länge proportionalen Ansteuerpegel für den Antrieb 62, also der dreiphasigen elektrischen Maschine 6 als Verbraucher 5 zum Antreiben der Lenkhilfe 60 der Lenkeinrichtung 20.

Zur Feststellung, ob eine Strommessung nach einem jeweiligen der Pulse 31-2, 32-2, 33-2 möglich ist, werden die Zeitspannen 31-5, 32-5, 33-5 nach der abfallenden Flanke des jeweiligen Pulses 31-2, 32-2, 33-2 im Zusammenhang mit einer entsprechend notwendigen Einschwingzeit 31-4, 32-4, 33-4 und der Zeitspannen 34, die für eine jeweilige Strommessung notwendig sind, betrachtet. Die Zeitspannen 31-5, 32-5, 33-5 nach der abfallenden Flanke eines jeweiligen Pulses 31-2, 32-2, 33-2 der Phasen U, V, W in einem aktuellen Takt erstreckt sich bis zum Zeitpunkt einer ansteigenden Flanke eines Pulses 31-2, 32-2, 33-2 der jeweiligen Phasen U, V, W im nachfolgenden Takt.

In der in Figur 3 dargestellten Situation sind selbst unter Berücksichtigung der Einschwingzeiten 31-4, 32-4, 33-4 die nach den Pulsen 31-2, 32-2, 33-2 nachfolgenden Zeitspannen 31-5, 32-5, 33-5 der Phasen Niedrigpegel 31-3, 32-3, 33-3 ausreichend, die Zeitspannen für die Messung der Ströme I_{U}, I_{V}, I_{W} zu den Phasen U, V, W mit den entsprechenden Abtastzeiten 34 auch unter Berücksichtigung der jeweiligen Einschwingzeiten bereitzustellen.

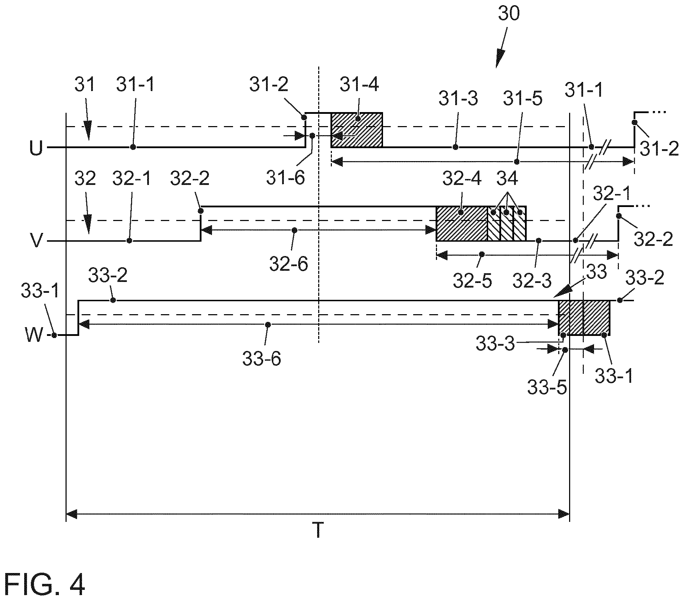

Bei der Situation gemäß Figur 4 ist der Zeitraum für die Messung der Ströme I_{U}, I_{V}, I_{W} zu den Phasen U, V, W nicht ausreichend, wie dies die Betrachtung der rechten Seite zur Spur 33 zur dritten Phase W ergibt. Dort reicht die Totzeit 33-4 bereits in den Beginn des nächsten Zyklus hinein, auch wenn im Hinblick auf die Phasen U und V eine Messung von zwei der Ströme I_{U}, I_{V}, I_{W} zu den Phasen U, V, W durchaus möglich wäre. Der fehlende Strom kann dann aus den zwei Messwerten berechnet werden. Die Messung von zwei Strömen ist aber nicht in allen Fällen ausreichend. Dann muss auf die vorangehend beschriebene aktive Maßnahme zurückgegriffen werden.

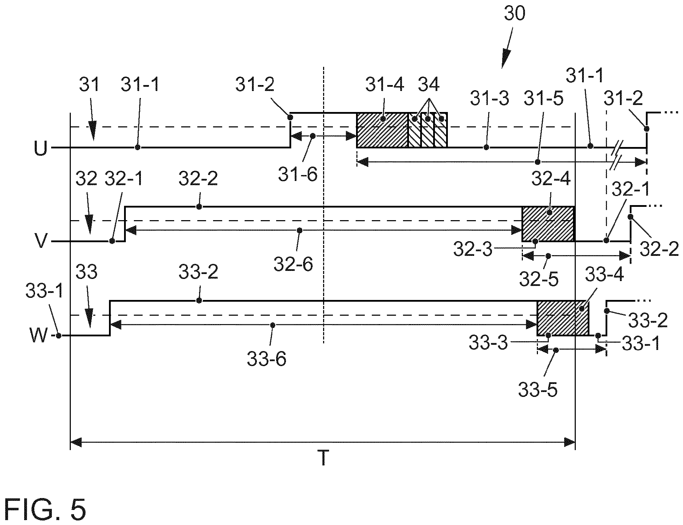

Figur 5 schildert der Situation, bei der auch eine Messung von zwei der drei Ströme I_{U}, I_{V}, I_{W} zu den Phasen U, V, W nicht möglich ist, wie dies die Betrachtung der rechten Seite des Zyklus' zu den Phasen V und W ergibt.

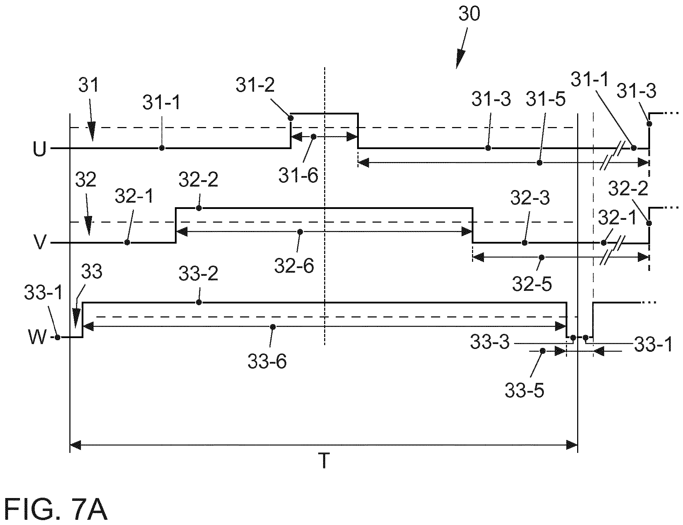

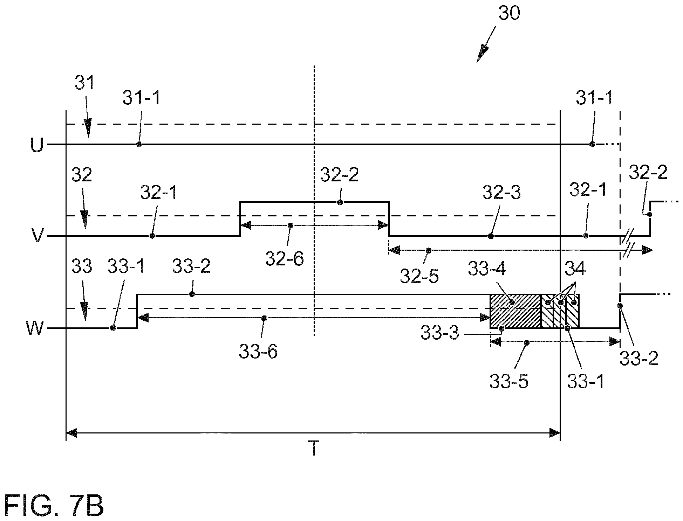

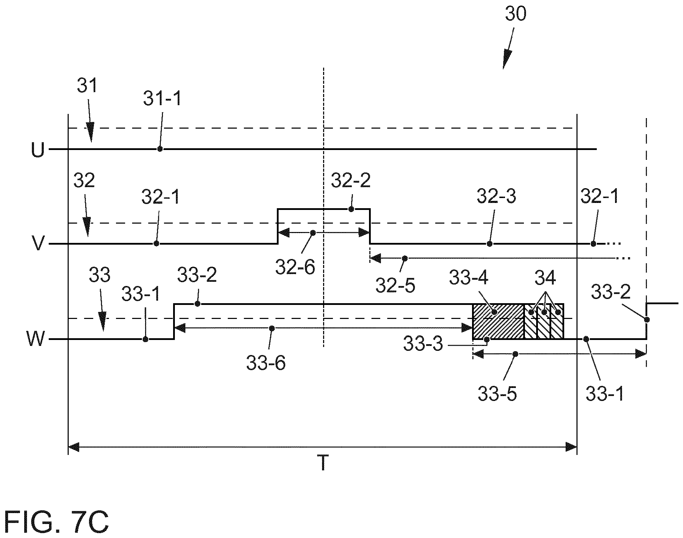

In den Figuren 3 bis 5 sowie 6A bis 7C können die Zeitspannen 31-5, 32-5 und insbesondere die Zeitspanne 33-5 jeweils in Beziehung gesetzt werden zu einer Ausschaltflanke einer jeweiligen Phase U, V, W in einem aktuellen Takt und einer Einschaltflanke der Phase mit dem längsten Modulationsmuster im nachfolgenden Takt.

Diese und weitere Aspekte, Merkmale und Eigenschaften der vorliegenden Erfindung werden an Hand der folgenden Darlegungen weiter erläutert:
Ferner betrifft die vorliegende Erfindung auch das Sicherstellen gültiger Strommesssamples bei einem elektromechanischen Lenksystem 20 durch aktive Veränderung der Ansteuerung eines Elektromotors als Antrieb 62.

Zur Erreichung der Sicherheitsziele eines elektromechanischen Lenksystems 20 ist es notwendig, zyklisch in einem Zeitraum von wenigen Millisekunden einen gültigen zeitgleich abgetasteten Strom auf allen drei Motorphasen U, V, W des Lenkungsservomotors als Antrieb 62 einer Lenkhilfe 60 zu messen.

Eine Messung von drei gültigen Strömen I_{U}, I_{V}, I_{W} zu den Phasen U, V, W ist aufgrund des zu geringen zeitlichen Auswerteintervalls bei hohen Aussteuergraden - das heißt bei großen Pulsweiten - nicht mehr möglich. Daher wird eine Möglichkeit vorgeschlagen, um zeitweise doch drei gültige Ströme messen zu können. Dabei wird die Ansteuerung 7 der Leistungselektronik 4 gemäß Figur 2 so manipuliert, dass zeitweise drei Ströme messbar sind.

### Problem 1

Um die Anforderung, dass in einem bestimmten Zeitraum mindestens für ein Sample alle drei Ströme I_{U}, I_{V}, I_{W} der Phasen U, V, W messbar sind, in allen Fällen umsetzen zu können, muss bei höheren Aussteuergraden eine aktive Maßnahme durchgeführt werden. Im Folgenden werden derartige Maßnahmen als "aktive Strommessung" bezeichnet.

### Lösung 1

Bei der aktiven Strommessung wird die Ansteuerung mittels Pulsweitenmodulation, nachfolgend auch mit PWM bezeichnet, für einen Auswertetakt so verändert, dass ein genügend großer Zeitraum für die Strommessung zur Verfügung steht. Die PWM wird dabei höchstens einmal in einem vorgegebenen Intervall von zum Beispiel 4,6 ms gestaucht. Dies führt zu einer Veränderung der Spannungswerte an den Motorklemmen und somit zu einem Strom- und Momentenfehler. Der Zeitwert von T2 = 4,6 ms ist hier nur als Beispiel gewählt, allgemein ist der Wert T2 deutlich länger bemessen als die oben beschriebene Zeitdauer T, zum Beispiel gemäß T2 > 50 · T.

Das erfindungsgemäße Verfahren soll insbesondere dafür sorgen, dass eine Messung in jedem Fall möglich ist und der entstehende Fehler minimiert oder unterdrückt wird.

Die aktive Strommessung wird unter folgenden Gesichtspunkten aktiviert:
- Innerhalb eines vorbestimmten längeren Zeitraums (z.B. 14 ms) war keine Messung von drei gültigen Strömen möglich. Für den hier beispielhaft gewählten längeren Zeitraum von 14 ms gelten die oben dargelegten Anmerkungen analog.
- Innerhalb eines vorbestimmten kürzeren Zeitraums (z.B. 4,6 ms) war keine Messung von zwei gültigen Strömen möglich. Auch hier gelten die obigen Anmerkungen zu dem beispielhaft gewählten Zeitraum von 4,6 ms analog.

Beide Kriterien können miteinander kombiniert werden.

Um die Anzahl der maximal messbaren Ströme zu ermitteln, werden konkret die aktuell generierten Ansteuerinformationen für die Leistungshalbleiter ausgewertet.

Für die Realisierung von drei messbaren Strömen muss zwischen der Ausschaltflanke des größten oder längsten PWM-Musters im aktuellen Takt und der Einschaltflanke des größten oder längsten PWM-Musters im nächsten Takt ein bestimmter Zeitraum (tSample) vorhanden sein. Dieser Zeitraum umfasst die Einschwingzeit der Strommessung und die Zeit für die Abtastung der drei Strommesskanäle. Ist dieser Zeitraum wiederholt zu klein, dann wird eine aktive Strommessung angefordert, wie dies im Zusammenhang mit Figur 4 erläutert ist.

Für die Realisierung von zwei messbaren Strömen muss zwischen der Ausschaltflanke des mittleren PWM-Musters im aktuellen Takt und der Einschaltflanke des größten oder längsten PWM-Musters im nächsten Takt ein Samplezeitraum (tSample), bestehend aus Einschwingzeit und Abtastzeit, vorhanden sein. Gemeint sind hier ganz allgemein Einschaltflanke des unteren Low-Side-Leistungshalbleiters und also der Beginn des Low-Pegels auf der Phase mit dem mittlerer Pulslänge und der Ausschaltflanke des High-Side-Leistungshalbleiters und also das Ende des High-Pegels auf der Phase mit dem längsten Puls. Da es sich bei der Messung um eine Messung im Low-Side-Pfad einer zu Grunde liegenden B6-Brücke gemäß Figur 1 handelt, ist bei dieser Art der Messung nur die Erfassung von zwei der drei Ströme möglich. Es existieren jedoch auch Szenarien, bei denen über längere Zeit keine Messung mit dieser Methode möglich ist, auch dann kann eine aktive Strommessung angefordert werden, wie dies im Zusammenhang mit Figur 4 erläutert ist.

Sobald die Notwendigkeit einer aktiven Strommessung erkannt wurde, sorgt der Algorithmus dafür, dass im nächsten Rechenzyklus die Ansteuerinformation der Leistungshalbleiter so manipuliert wird, dass eine Messung von allen drei Strömen ermöglicht wird, und zwar unabhängig davon, ob eine Zwei- oder ein Dreistrommessung notwendig ist.

Die Umsetzung der Manipulation umfasst zwei Maßnahmen, die aktiviert werden können. Wir unterscheiden drei Fälle:
Fall 1: Die Spannungen im Rechenzyklus, in dem eine aktive Strommessung erfolgen soll, sind kleiner als 50% des maximalen Aussteuergrads. Dann ist keine aktive Maßnahme notwendig. Es können drei Ströme gemessen werden.
Fall 2: Die Spannungen im Rechenzyklus, in dem eine aktive Strommessung erfolgen soll, sind größer als 50%, jedoch kleiner als 74,5% des maximalen Aussteuergrads. In diesem Fall wird das Modulationsverfahren auf die Flattopmodulation umgeschaltet und somit ein genügend großer Zeitraum für die Messung von drei gültigen Strömen geschaffen. Die gestellten Spannungen werden nicht verfälscht und somit bildet sich kein Strom- oder Momentenfehler aus.
Fall 3: Die Spannungen im Rechenzyklus, in dem eine aktive Strommessung erfolgen soll, sind größer als 74,5% des maximalen Aussteuergrads. In diesem Fall wird erneut die Modulationsart auf Flattopmodulation umgeschaltet. Zusätzlich erfolgt eine Stauchung der Eingangsspannungen, die für die Ermittlung der PWM-Muster verwendet werden. Es wird so gestaucht, dass der Aussteuergrad nach der Stauchung genau 74,5% des maximal möglichen Aussteuergrads entspricht. Dann ist sichergestellt, dass die resultierenden PWM-Muster immer eine Messung von drei Strömen ermöglichen. Bei dieser Methode entsteht ein Strom- sowie Momentenfehler im Motor.

Die angegebenen Prozentwerte dienen hier nur der Illustration und sind rein beispielhaft und an einen jeweiligen Anwendungsfall konkret anzupassen.

### Beschreibung weiterer Ausführunasbeispiele 1

Zur weiteren Reduktion des Strom- bzw. Momentenfehlers im Fall 3 des oben beschriebenen Verfahrens kann statt der Stauchung der Eingangsspannungen eine Begrenzung der berechneten PWM-Muster auf eine maximal mögliche Pulsweite durchgeführt werden. Durch diese Art der Begrenzung wird nicht der gesamte Spannungsvektor beeinflusst sondern meistens nur die Spannung einer Phase.

Diese Ausführung zeigt im Mittel einen geringeren Strom- bzw. Momentenfehler als das oben beschriebene Verfahren.

Die vorliegende Erfindung betrifft des Weiteren die Verringerung akustisch störender Effekte bei einer aktiven Strommessung, insbesondere bei elektromechanischen Lenksystemen.

Zur Erreichung der Sicherheitsziele eines elektromechanischen Lenksystems ist es notwendig, zyklisch in einem Zeitraum von wenigen Millisekunden einen gültigen zeitgleich abgetasteten Strom auf allen drei Motorphasen des Lenkungsservomotors zu messen. Da eine Messung von drei gültigen Strömen bei hohen Aussteuergraden nicht mehr möglich ist, wurde eine Möglichkeit gesucht, um zeitweise doch drei gültige Ströme messen zu können. Dabei wird die Ansteuerung der Leistungselektronik so manipuliert, dass zeitweise drei Ströme messbar sind. Dies führt jedoch zu Problemen, da sich ein störender Ton ausbildet, der im Fahrzeug stark wahrnehmbar ist. Dieser Ton soll eliminiert bzw. minimiert werden.

### Problem 2

Um die Anforderung, dass in einem bestimmten Zeitraum mindestens für ein Sample drei Ströme messbar sein müssen, in allen Fällen umsetzen zu können, muss bei höheren Aussteuergraden eine aktive Maßnahme durchgeführt werden, die auch als "aktive Strommessung" bezeichnet wird.

Dabei wird - wie dies oben bereits erläutert wurde - die Ansteuerung mittels PWM für einen Auswertetakt so verändert, dass ein genügend großer Zeitraum für die Strommessung zur Verfügung steht.

Die PWM wird dabei z.B. alle 4,6 ms gestaucht. Dies führt zu einer Veränderung der Spannungswerte an den Motorklemmen und somit zu einem Strom- und Momentenfehler. Dieser ist akustisch als sehr störender Ton mit 217 Hz und bei ganzzahligen Vielfachen dieser Frequenz wahrnehmbar.

### Lösung 2

Um diesen endkundenrelevanten Ton eliminieren bzw. abschwächen zu können, mussten mehrere Detaillösungen kombiniert werden.

### 1. Zufällige Abtastung

In der originalen Lösung erfolgt alle 4,6 ms eine aktive Strommessung. Dadurch bilden sich bestimmte Frequenzen sehr stark aus, andere Frequenzen sind aber nur sehr gering ausgeprägt. Durch die zufällige Abtastung wird der Messwert nicht mehr äquidistant aufgenommen sondern zufällig über einen Messzeitraum verschoben. Dabei verändert sich das Tonspektrum und wird breiter. Es sind mehrere Frequenzen involviert und die Energie verteilt sich auf diese Frequenzen. Zusätzlich wurde analysiert, ob mit einer deterministischen Verteilung der Abtastzeitpunkte eine noch bessere Verteilung der Energie auf mehrere Frequenzen erzielt werden kann. Es hat sich gezeigt, dass die Verteilung konkret vom Abtastschema abhängt. Daher ist in der finalen Lösung eine bestimmte Abfolge vorgegeben, die eine optimale Verteilung des störenden Tons auf viele Frequenzen ermöglicht.

### 2. Vergrößerung des Abtastzeitraums

Eine weitere Verbesserung des Tonspektrums erfolgt über die Erhöhung des Abtastzeitraums von 4,6 ms auf 14,4 ms. Hierdurch wird eine noch breitere Verteilung der Energie auf Tonfrequenzen erzielt und damit der wahrnehmbare Ton noch besser unterdrückt.

### 3. Verringerung des tonerzeugenden Effekts

Zusätzlich zur Lösung 2 konnten noch zwei Maßnahmen entwickelt werden, die konkret die aktive Strommessung verbessern und damit den Momentenfehler, der aus der Manipulation der PWM-Muster entsteht, reduzieren.

Ursprünglich war die Manipulation der PWM durch die aktive Strommessung für 4 · 50 µs aktiv. Da aber nur zwei Strommesssamples ausgewertet werden und dafür nur drei PWM-Zyklen manipuliert werden müssen, kann die Dauer der Manipulation auf 3 · 50 µs verringert werden.

### Beschreibung weiterer Ausführungsbeispiele 2

Zur weiteren Reduktion des störenden Effekts können weitere Maßnahmen umgesetzt werden. Angelehnt an Maßnahme 3 existieren auch Möglichkeiten die Manipulationsdauer von 3 · 50 µs auf entweder 2 · 50 µs oder sogar 1 · 50 µs zu reduzieren. Jedoch steigt der Änderungsaufwand für jeden weiteren Optimierungsschritt stark an, da immer mehr SW-Komponenten diese Manipulation genau kennen und darauf individuell reagieren müssen.

Bei der Reduktion auf 2 · 50 µs muss bei der Auswertung der Strommesswerte von zwei Samples pro Phase auf ein Sample pro Phase gewechselt werden.

Für die Reduktion auf 1 · 50 µs muss zusätzlich zum Wechsel auf ein Strommesssample pro Phase auch noch eine Anpassung der PWM-Strategie vollzogen werden. In der aktuellen Implementierung wird eine mit dem jeweiligen Puls zentral ausgerichtete oder center-aligned PWM umgesetzt. Für dieses Verfahren müssten die PWM-Muster aus der Mitte an den Rand geschoben werden um zwischen zwei PWM-Zyklen ein gültiges Stromsample für jede Phase messen zu können.

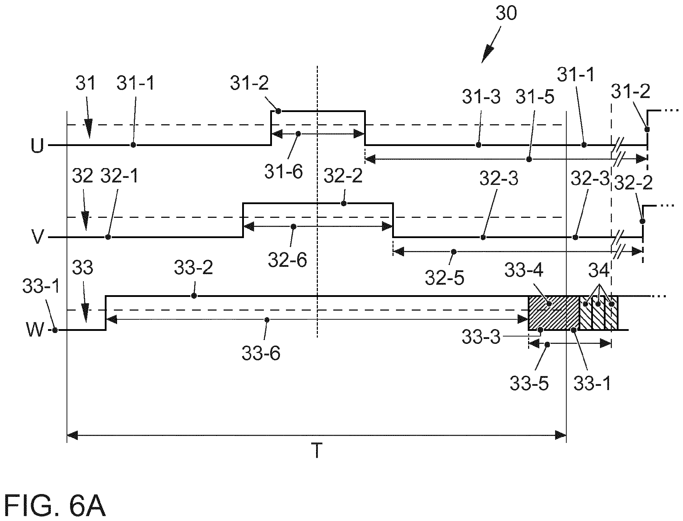

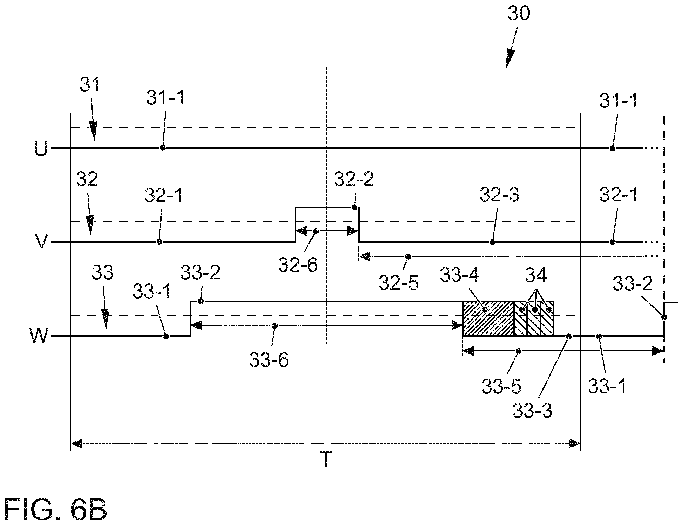

Die Figuren 6A bis 7C illustrieren das Vorgehen beim Übergang zur so genannten Flattopmodulation mit und ohne Stauchung.

Auch wenn die erfindungsgemäßen Aspekte und vorteilhaften Ausführungsformen anhand der in Verbindung mit den beigefügten Figuren 1 bis 7C erläuterten Ausführungsbeispiele im Detail beschrieben worden sind, sind für den Fachmann Modifikationen und Kombinationen von Merkmalen der dargestellten Ausführungsbeispiele möglich, ohne den Bereich der vorliegenden Erfindung zu verlassen, deren Schutzbereich durch die beigefügten Ansprüche definiert wird.

### Bezugszeichenliste

- 1: Wechselrichter, Brückenschaltung
- 1-1: Knoten
- 1-2: Knoten
- 1-3: Knoten
- 2: Gleichstromkreis
- 3-1: (erster) Brückenzweig
- 3-2: (zweiter) Brückenzweig
- 3-3: (dritter) Brückenzweig
- 4: Schaltelement, Halbleiterschaltelement
- 5: Verbraucher
- 5-1: Induktivität
- 5-2: Knoten, Sternknoten
- 6: (dreiphasige) elektrische Maschine, Asynchronmotor, Synchronmotor
- 7: Steuereingang
- 8: Gleichstromzwischenkreis
- 9: Zwischenkreiskondensator
- 10: Messwiderstand, Shunt
- 11: Messwertwandler
- 12: Messeinrichtung
- 13: Gleichspannungsquelle, Batterie
- 20: Lenkeinrichtung
- 21: Lenkrad
- 22: (primäre) Lenkwelle
- 23: (sekundäre) Lenkwelle
- 24: Lenkgetriebe
- 25: Lenkmittel, Querlenker, Aufhängung
- 26: Torsionsstab
- 27: Winkellagesensor
- 28: Erfassungsleitung
- 30: Graph, Anregungsschema
- 31: Spur zur ersten Phase oder Phase U
- 31-1: Abschnitt mit niedrigem Pegel
- 31-2: Abschnitt mit hohem Pegel, Puls
- 31-3: Abschnitt mit niedrigem Pegel
- 31-4: Totphase, Totzeit
- 31-5: Zeitspanne nach Puls 31-2
- 31-6: Zeitspanne des Pulses 31-2
- 32: Spur zur zweiten Phase oder Phase V
- 32-1: Abschnitt mit niedrigem Pegel
- 32-2: Abschnitt mit hohem Pegel, Puls
- 32-3: Abschnitt mit niedrigem Pegel
- 32-4: Totphase, Totzeit
- 32-5: Zeitspanne nach Puls 32-2
- 32-6: Zeitspanne des Pulses 32-2
- 33: Spur zur dritten Phase oder Phase W
- 33-1: Abschnitt mit niedrigem Pegel
- 33-2: Abschnitt mit hohem Pegel, Puls
- 33-3: Abschnitt mit niedrigem Pegel
- 33-4: Totphase, Totzeit
- 33-5: Zeitspanne nach Puls 33-2
- 33-6: Zeitspanne des Pulses 33-2

- 60: Lenkhilfe
- 61: Steuereinheit
- 62: Antrieb
- 63: Erfassungs- und Steuerleitung

- 100: Fahrzeug, Arbeitsvorrichtung, Vorrichtung

## Patentansprüche

1. Strommessverfahren bei einem Betriebsverfahren für einen mittels eines Modulationsmusters in Pulsweitenmodulation betriebenen mit drei Phasen (U, V, W) dreiphasigen elektromechanischen Antrieb (62) einer Lenkhilfe (60), **dadurch gekennzeichnet, dass** zu bestimmten Auswertezeiten zeitgleich Ströme (I_{U}, I_{V}, I_{W}) zu den drei Phasen (U, V, W) erfasst werden,
- wobei beim Vorliegen einer vordefinierten Bedingung für eine aktive Strommessung zu einer Auswertezeit
- das Modulationsmuster einer der Phasen (U, V, W) durch Stauchung derart modifiziert wird, dass zu der Auswertezeit zwischen einer Ausschaltflanke der Phase (U, V, W) mit dem längsten Modulationsmuster unter den Phasen (U, V, W) im aktuellen Takt und einer Einschaltflanke der Phase (U, V, W) mit dem längsten Modulationsmuster unter den Phasen (U, V, W) im nachfolgenden Takt eine für eine mehrfache Strommessung ausreichende Messzeitspanne geschaffen wird,
wenn Steuerspannungen zu den Modulationsmustern und Pulsbreiten der Modulationsmuster zu den drei Phasen (U, V, W) oberhalb vorgegebener maximaler Grenzen eines Anteils eines maximalen Ansteuergrads bzw. einer maximalen Pulsbreite liegen, und
- zu der Auswertezeit in der Messzeitspanne zeitgleich eine Strommessung zu den drei Phasen (U, V, W) durchgeführt wird, und
- bei welchem auf das Vorliegen der vordefinierten Bedingung für eine aktive Strommessung erkannt wird,
- wenn innerhalb einer ersten bestimmten Zeitspanne seit einer letzten Strommessung keine Messung der Ströme (I_{U}, I_{V}, I_{W}) zu allen drei Phasen (U, V, W) durchgeführt wurde oder werden konnte oder
- wenn innerhalb einer zweiten bestimmten Zeitspanne seit einer letzten Strommessung keine Messung der Ströme (I_{U}, I_{V}, I_{W}) zu zwei der drei Phasen (U, V, W) durchgeführt wurde oder werden konnte,
- wobei die erste bestimmte Zeitspanne länger ist als die zweite bestimmte Zeitspanne.

2. Strommessverfahren nach Anspruch 1, bei welchem mindestens eine der ersten Zeitspanne und der zweiten Zeitspanne (i) für jeden Takt oder Messdurchgang zufällig, (ii) gemäß vorgegebener Wahrscheinlichkeitsverteilungen, (iii) auf einen Wert innerhalb vorgegebener maximaler Zeitspannen und/oder (iv) auf einen Wert im Bereich von 14 ms bzw. von 4,6 ms bestimmt werden.

3. Strommessverfahren nach einem der vorangehenden Ansprüche, bei welchem beim Vorliegen der vordefinierten Bedingung für eine aktive Strommessung eine Strommessung der Ströme (I_{U}, I_{V}, I_{W}) zu allen drei Phasen (U, V, W) ohne Änderung der Modulationsmuster durchgeführt wird, wenn die Steuerspannungen zu den Modulationsmustern und die Pulsbreiten der Modulationsmuster zu den drei Phasen (U, V, W) eine minimale Grenze von insbesondere 50 % eines maximalen Ansteuergrads und/oder einer maximalen Pulsbreite nicht überschreiten.

4. Strommessverfahren nach einem der vorangehenden Ansprüche, bei welchem beim Vorliegen der vordefinierten Bedingung für eine aktive Strommessung auf eine Flattopmodulation umgeschaltet und eine Strommessung der Ströme (I_{U}, I_{V}, I_{W}) zu allen drei Phasen (U, V, W) durchgeführt wird, wenn die Steuerspannungen zu den Modulationsmustern und die Pulsbreiten der Modulationsmuster zu den drei Phasen (U, V, W) zwischen einer minimalen Grenze von insbesondere 50 % und der maximalen oberen Grenze von insbesondere 68 % und vorzugsweise 74,5 % des maximalen Ansteuergrads und/oder der maximalen Pulsbreite liegen.

5. Strommessverfahren nach einem der vorangehenden Ansprüche, bei welchem beim Vorliegen der vordefinierten Bedingung für eine aktive Strommessung (i) auf eine Flattopmodulation umgeschaltet wird, (ii) die Steuerspannungen zu den Modulationsmustern und die Pulsbreiten der Modulationsmuster zu den drei Phasen (U, V, W) auf die maximale obere Grenze von insbesondere 68 % und vorzugsweise 74,5 % des maximalen Ansteuergrads bzw. der maximalen Pulsbreite eingestellt werden und (iii) eine Strommessung der Ströme (I_{U}, I_{V}, I_{W}) zu allen drei Phasen (U, V, W) durchgeführt wird, wenn die Steuerspannungen zu den Modulationsmustern und die Pulsbreiten der Modulationsmuster zu den drei Phasen (U, V, W) oberhalb der maximalen oberen Grenze von insbesondere 68 % und vorzugsweise 74,5 % des maximalen Ansteuergrads und/oder der maximalen Pulsbreite liegen.

6. Strommessverfahren nach einem der vorangehenden Ansprüche, bei welchem die Stauchung des Modulationsmusters oder der Modulationsmuster für eine Zeitspanne erfolgt, welche (i) höchstens in etwa dem Vierfachen einer zu Grunde liegenden Zykluszeit der Pulsweitenmodulation, (ii) höchstens in etwa dem Dreifachen der zu Grunde liegenden Zykluszeit oder (iii), dem Zweifachen (iv) oder der zu Grunde liegenden Zykluszeit selbst entspricht.

7. Strommessverfahren nach einem der vorangehenden Ansprüche, bei welchem eine der Pulsweitenmodulation zu Grunde liegenden Zykluszeit 50 µs beträgt.

8. Betriebsverfahren für einen mittels eines Modulationsmusters in Pulsweitenmodulation betriebenen dreiphasigen elektromechanischen Antriebs (62) einer Lenkhilfe (60), bei welchem zur Regelung oder zur Plausibilisierung eines Betriebs oder einer Stellung eines Lenkmittels (25) oder des Antriebs (62) der Lenkhilfe (60) ein Strommessverfahren nach einem der Ansprüche 1 bis 7 durchgeführt wird.

9. Lenkhilfe (60) zur Unterstützung beim Lenken eines Fahrzeugs (100) mittels eines Lenkmittels (25) einer Lenkeinrichtung (20), mit einer Steuereinheit (61), welche eingerichtet ist, ein Betriebsverfahren nach Anspruch 8 und/oder ein Strommessverfahren nach einem der Ansprüche 1 bis 7 auszuführen.

10. Computerprogrammerzeugnis mit einem Computerprogrammcode, welcher eingerichtet ist zu bewirken, dass auf einem Computer oder einem digitalen Signalverarbeitungsprozessor ein Betriebsverfahren nach Anspruch 8 und/oder ein Strommessverfahren nach einem der Ansprüche 1 bis 7 veranlasst wird, wenn auf dem Computer und/oder dem digitalen Signalverarbeitungsprozessor der Computerprogrammcode abläuft.

11. Arbeitsvorrichtung, mit einer Lenkeinrichtung (20), welche ein Lenkmittel (25) und eine Lenkhilfe (60) nach Anspruch 9 aufweist.

## Claims

1. Current measuring method in an operating method for a three-phase electromechanical drive (62) of a steering aid (60), said drive with three phases (U, V, W) and being operated with pulse-width modulation by means of a modulation pattern,
**characterized in that**
- currents (I_{U}, I_{V}, I_{W}) for the three phases (U, V, W) are recorded simultaneously at specific evaluation times,
- wherein, if a predefined condition for active current measurement is present at an evaluation time,
- the modulation pattern of one of the phases (U, V, W) is modified by compression such that, at the evaluation time, a sufficient measuring period for performing multiple current measurements is produced between a falling edge of the phase (U, V, W) that has the longest modulation pattern among the phases (U, V, W) in the current cycle and a rising edge of the phase (U, V, W) that has the longest modulation pattern among the phases (U, V, W) in the following cycle,
if control voltages for the modulation patterns and pulse widths of the modulation patterns for the three phases (U, V, W) are above predetermined maximum limits of a proportion of a maximum duty cycle and of a maximum pulse width, respectively, and
- a current measurement for the three phases (U, V, W) is carried out simultaneously in the measuring period at the evaluation time, and
- wherein the presence of the predefined condition for active current measurement is detected
- if, within a first specific period since a last current measurement, a measurement of the currents (I_{U}, I_{V}, I_{W}) for all three phases (U, V, W) has not been carried out or has not been able to be carried out, or
- if, within a second specific period since a last current measurement, a measurement of the currents (I_{U}, I_{V}, I_{W}) for two of the three phases (U, V, W) has not been carried out or has not been able to be carried out,
- wherein the first specific period is longer than the second specific period.

2. Current measuring method according to Claim 1, wherein at least one of the first period and the second period is determined (i) randomly for each cycle or measurement run, (ii) according to predetermined probability distributions, (iii) at a value within predetermined maximum periods, and/or (iv) at a value in the region of 14 ms and 4.6 ms, respectively.

3. Current measuring method according to either of the preceding claims, wherein, if the predefined condition for active current measurement is present, a current measurement of the currents (I_{U}, I_{V}, I_{W}) for all three phases (U, V, W) is carried out without changing the modulation patterns, if the control voltages for the modulation patterns and the pulse widths of the modulation patterns for the three phases (U, V, W) do not exceed a minimum limit of in particular 50% of a maximum duty cycle and/or of a maximum pulse width.

4. Current measuring method according to one of the preceding claims, wherein, if the predefined condition for active current measurement is present, a switch is made to flat-top modulation and a current measurement of the currents (I_{U}, I_{V}, I_{W}) for all three phases (U, V, W) is carried out, if the control voltages for the modulation patterns and the pulse widths of the modulation patterns for the three phases (U, V, W) are between a minimum limit of in particular 50% and the maximum upper limit of in particular 68% and preferably 74.5% of the maximum duty cycle and/or of the maximum pulse width.

5. Current measuring method according to one of the preceding claims, wherein, if the predefined condition for active current measurement is present, (i) a switch is made to flat-top modulation, (ii) the control voltages for the modulation patterns and the pulse widths of the modulation patterns for the three phases (U, V, W) are set to the maximum upper limit of in particular 68% and preferably 74.5% of the maximum duty cycle and of the maximum pulse width, respectively, and (iii) a current measurement of the currents (I_{U}, I_{V}, I_{W}) for all three phases (U, V, W) is carried out, if the control voltages for the modulation patterns and the pulse widths of the modulation patterns for the three phases (U, V, W) are above the maximum upper limit of in particular 68% and preferably 74.5% of the maximum duty cycle and/or of the maximum pulse width.

6. Current measuring method according to one of the preceding claims, wherein the compression of the modulation pattern or patterns takes place for a period which corresponds (i) at most approximately to four times an underlying cycle time of the pulse-width modulation, (ii) at most approximately to three times the underlying cycle time or (iii) to twice or (iv) to the underlying cycle time itself.

7. Current measuring method according to one of the preceding claims, wherein an underlying cycle time of the pulse-width modulation is 50 µs.

8. Operating method for a three-phase electromechanical drive (62) of a steering aid (60), said drive being operated with pulse-width modulation by means of a modulation pattern, wherein a current measuring method according to one of Claims 1 to 7 is carried out in order to regulate or check the plausibility of the operation or of a position of a steering means (25) or of the drive (62) of the steering aid (60).

9. Steering aid (60) for assistance in steering a vehicle (100) by means of a steering means (25) of a steering device (20), comprising a control unit (61), which is set up to carry out an operating method according to Claim 8 and/or a current measuring method according to one of Claims 1 to 7.

10. Computer program product comprising computer program code, which is set up to cause an operating method according to Claim 8 and/or a current measuring method according to one of Claims 1 to 7 to be initiated on a computer or on a digital signal processor when the computer program code runs on the computer and/or the digital signal processor.

11. Work apparatus comprising a steering device (20) which has a steering means (25) and a steering aid (60) according to Claim 9.

## Revendications

1. Procédé de mesure de courant dans un procédé de fonctionnement d'un entraînement électromécanique triphasé (62) avec trois phases (U, V, W) d'une assistance de direction (60) fonctionnant en modulation de largeur d'impulsion au moyen d'un motif de modulation, **caractérisé en ce que**
- des courants (I_{U}, I_{V}, I_{W}) appliqués aux trois phases (U, V, W) sont détectés simultanément à des instants d'évaluation déterminés,
- dans lequel, en présence d'une condition prédéfinie pour une mesure de courant active à un instant d'évaluation,
- le motif de modulation de l'une des phases (U, V, W) est modifié par compression de telle sorte qu'à l'instant d'évaluation, entre un front de désactivation de la phase (U, V, W) présentant le motif de modulation le plus long parmi les phases (U, V, W) dans le cycle d'horloge actuel et un front d'activation de la phase (U, V, W) présentant le motif de modulation le plus long parmi les phases (U, V, W) dans le cycle d'horloge suivant, un intervalle de temps de mesure suffisant pour une mesure multiple du courant est créé,
lorsque des tensions de commande destinées aux motifs de modulation et des largeurs d'impulsion des motifs de modulation destinés aux trois phases (U, V, W) sont supérieures à des limites maximales prédéfinies d'une fraction d'un degré de commande maximal ou d'une largeur d'impulsion maximale, et
- une mesure de courant sur les trois phases (U, V, W) est effectuée simultanément à l'instant d'évaluation au cours de l'intervalle de temps de mesure, et
- dans lequel la présence de la condition prédéfinie est détectée pour une mesure de courant active,
- lorsqu'aucune mesure des courants (I_{U}, I_{V}, I_{W}) appliqués à la totalité des trois phases (U, V, W) n'a été ou n'a pu être effectuée au cours d'un premier intervalle de temps déterminé depuis une dernière mesure de courant ou
- lorsqu'aucune mesure des courants (I_{U}, I_{V}, I_{W}) appliqués à deux des trois phases (U, V, W) n'a été ou n'a pu être effectuée au cours d'un deuxième intervalle de temps déterminé depuis une dernière mesure de courant,
- dans lequel le premier intervalle de temps déterminé est plus long que le deuxième intervalle de temps déterminé.

2. Procédé de mesure de courant selon la revendication 1, dans lequel au moins l'un du premier intervalle de temps et du deuxième intervalle de temps est déterminé (i) de manière aléatoire pour chaque cycle d'horloge ou processus de mesure, (ii) selon des distributions de probabilité prédéterminées, (iii) à une valeur comprise dans des intervalles de temps maximaux prédéterminés et/ou (iv) à une valeur respectivement de l'ordre de 14 ms et de 4,6 ms.

3. Procédé de mesure de courant selon l'une des revendications précédentes, dans lequel, en présence de la condition prédéfinie pour une mesure de courant active, une mesure de courant portant sur les courants (I_{U}, I_{V}, I_{W}) appliqués à la totalité des trois phases (U, V, W) est effectuée sans modification des motifs de modulation lorsque les tensions de commande appliquées aux motifs de modulation et les largeurs d'impulsion des motifs de modulation appliqués aux trois phases (U, V, W) ne dépassent pas une limite minimale, notamment de 50 %, d'un degré de commande maximal et/ou d'une largeur d'impulsion maximale.

4. Procédé de mesure de courant selon l'une des revendications précédentes, dans lequel, en présence de la condition prédéfinie pour une mesure de courant active, un basculement sur une modulation en haut de forme est effectué et une mesure de courant portant sur les courants (I_{U}, I_{V}, I_{W}) appliqués aux trois phases (U, V, W) est effectuée lorsque les tensions de commande appliquées aux motifs de modulation et les largeurs d'impulsion des motifs de modulation appliqués aux trois phases (U, V, W) se situent entre une limite minimale notamment de 50 % et la limite supérieure maximale notamment de 68 % et de préférence de 74,5 % du degré de commande maximal et/ou de la largeur d'impulsion maximale.

5. Procédé de mesure de courant selon l'une des revendications précédentes, dans lequel, en présence de la condition prédéfinie pour une mesure de courant active, (i) un basculement sur une modulation en haut de forme est effectué, (ii) les tensions de commande appliquées aux motifs de modulation et les largeurs d'impulsion des motifs de modulation appliqués aux trois phases (U, V, W) sont respectivement fixées à la limite supérieure maximale, notamment de 68 % et de préférence de 74,5 % du degré de commande maximal et de la largeur d'impulsion maximale et (iii) une mesure de courant portant sur les courants (I_{U}, I_{V}, I_{W}) appliqués à la totalité des trois phases (U, V, W) est effectuée lorsque les tensions de commande appliquées aux motifs de modulation et les largeurs d'impulsion des motifs de modulation appliqués aux trois phases (U, V, W) sont supérieures à la limite supérieure maximale, notamment de 68 % et de préférence de 74,5 % du degré de commande maximal et/ou de la largeur d'impulsion maximale.

6. Procédé de mesure de courant selon l'une des revendications précédentes, dans lequel la compression du motif de modulation ou des motifs de modulation est effectuée pendant un intervalle de temps correspondant (i) au plus à environ quatre fois un temps de cycle sous-jacent de la modulation de largeur d'impulsion, (ii) au plus à environ trois fois le temps de cycle sous-jacent ou (iii), à deux fois ou (iv) à une fois le temps de cycle sous-jacent lui-même.

7. Procédé de mesure de courant selon l'une des revendications précédentes, dans lequel un temps de cycle sous-jacent à la modulation de largeur d'impulsion est de 50 µs.

8. Procédé de fonctionnement d'un entraînement électromécanique triphasé (62) d'une assistance de direction (60) fonctionnant en modulation de largeur d'impulsion au moyen d'un motif de modulation, dans lequel, pour réguler ou pour rendre plausible un fonctionnement ou une position d'un moyen de direction (25) ou de l'entraînement (62) de l'assistance de direction (60), un procédé de mesure de courant selon l'une des revendications 1 à 7 est mis en œuvre.

9. Assistance de direction (60) pour l'aide à la direction d'un véhicule (100) au moyen d'un moyen de direction (25) d'un dispositif de direction (20), comprenant une unité de commande (61) qui est conçue pour mettre en œuvre un procédé de fonctionnement selon la revendication 8 et/ou un procédé de mesure de courant selon l'une des revendications 1 à 7.

10. Produit de programme informatique comprenant un code de programme informatique qui est conçu pour provoquer, sur un ordinateur ou un processeur de traitement de signal numérique, la mise en œuvre d'un procédé de fonctionnement selon la revendication 8 et/ou d'un procédé de mesure de courant selon l'une des revendications 1 à 7, lorsque le code de programme informatique est exécuté sur l'ordinateur et/ou le processeur de traitement de signal numérique.

11. Dispositif de travail comprenant un dispositif de direction (20) qui comporte un moyen de direction (25) et une assistance de direction (60) selon la revendication 9.
